(19) Europäisches Patentamt
European Patent Office
Office européen des brevets

(11) **EP 4 300 111 A1**

(12) **EUROPEAN PATENT APPLICATION**

(43) Date of publication:
**03.01.2024 Bulletin 2024/01**

(21) Application number: **23180316.4**

(22) Date of filing: **20.06.2023**

(51) International Patent Classification (IPC):
**G01R 31/382** (2019.01)   **G01R 31/392** (2019.01)
**G01R 31/396** (2019.01)

(52) Cooperative Patent Classification (CPC):
**G01R 31/392; G01R 31/382; G01R 31/396;**
G01R 31/374

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **28.06.2022 IN 202211036943**

(71) Applicant: **Exicom Tele-Systems Limited
Bangalore 122015 (IN)**

(72) Inventors:
• **K.V., Sundaraaman**
  **Yelahanka (IN)**
• **AHAMAD, Salahuddin**
  **Yelahanka (IN)**
• **SINGH, Parmender**
  **Yelahanka (IN)**

(74) Representative: **Lewis Silkin LLP
Arbor
255 Blackfriars Road
London SE1 9AX (GB)**

(54) **SYSTEM FOR ESTIMATION OF STATE OF HEALTH OF BATTERY PACK AND METHOD THEREOF**

(57)     A method (400) and system (105) for estimation of State of Health (SOH) of a battery pack (110) is provided. The method includes determining a first SOH (410) utilizing a set of operational parameters and a first set of stress parameters and a second SOH (415) based on a determined discharge capacity. Utilizing the first and the second SOH (425), determine a second set of stress parameters of the battery pack. The method includes determining a third SOH (435) of the battery pack based on at least one selected second set of stress parameters and the set of operational parameters and determining a deviation parameter based on the first and the third SOH. Thereafter, the method includes transmitting an ideal SOH signal (445) to one of a server and a user device in response to the determined deviation parameter being greater than a pre-defined threshold.

**FIG. 2**

EP 4 300 111 A1

**Description**

FIELD OF THE INVENTION

The present invention relates to a battery pack and more particularly relates to State of Health (SOH) of the battery pack.

BACKGROUND OF THE INVENTION

Electric energy stored in devices such as batteries are, of late being used as energy sources in applications such as transportation, telecom and the like. These batteries include multiple cells connected to one another in one of series and parallel, and combination thereof. During operation, the batteries are subject to charging and discharging processes repeatedly. However, the battery tends to undergo an irreversible capacity degradation due to various side reactions and physical changes that may occur during charging/discharging process, leading to performance deterioration and limiting cycle life of the battery.

One of the most common and fundamental source of capacity degradation is the loss of cyclable lithium of at least one of the multiple cells of the battery pack to the solid-electrolyte interphase (SEI). In most cases, the SEI is formed at the negative electrode during charging process. During the initial phase of charging/discharging process, a stable SEI protects the electrode against solvent decomposition during charging near zero voltage. However, on completion of multiple charging/discharging processes performed by the battery pack, the SEI layer tends to thicken leading to a gradual capacity loss. Secondly, during the charging/discharging process of the battery pack, mechanical stresses are exerted on electrodes of the battery pack causing particle fracture, reducing electrode porosity, and breaking electronic network pathways.

State of health (SOH) is a parameter quantitatively representing change of battery capacity characteristics caused by an aging effect and indicates degree of battery capacity degradation. Therefore, if an accurate SOH is estimated, a battery can be replaced at a proper time and can be protected from over-charging and over-discharging by controlling battery capacity for charge and discharge based on the battery usage time.

In view of the above, there is a dire requirement for a system for estimation of the accurate SOH of the battery pack.

BRIEF SUMMARY OF THE INVENTION

One or more embodiments of the present invention provide a system and method for estimation of a State of Health (SOH) of a battery pack.

In one aspect of the invention, a method for estimation of State of Health (SOH) of a battery pack is provided. The method includes receiving, at a transceiver, a set of operational parameters pertaining to an operation of each of a plurality of cells of the battery pack. On receiving, the method includes determining, by the processor, a first state of health of the battery pack utilizing the set of operational parameters and a first set of stress parameters. Subsequently, the method includes receiving, at the transceiver, a discharge profile of one an exemplary battery pack and the battery pack to determine a discharge capacity of one of the exemplary battery pack and the battery pack utilizing the discharge profile. Based on the discharge profile, the method includes determining, by the processor, a second state of health of the battery pack based on the determined discharge capacity. Thereafter, the method includes utilizing, by the processor, the first state of health and the second state of health to determine a second set of stress parameters of the battery pack for each of a plurality of State of Charge (SOC) ranges of the battery pack. Further, the method includes dynamically selecting, by the processor, at least of the second set of stress parameters from the second set of stress parameters, wherein the at least one of the second set of stress parameters corresponds to at least one SOC range of the plurality of SOC ranges. Thereafter, the method includes determining, by the processor, a third state of health of the battery pack based on the at least one selected second set of stress parameters and the set of operational parameters. Further, the method includes determining, by the processor, a deviation parameter based on the first and the third state of health of the battery pack. Furthermore, the method includes transmitting, by the processor, an ideal state of health signal to one of a server and a user device of an electric vehicle in response to the determined deviation parameter being greater than a pre-defined threshold.

In another aspect of the invention, a system for estimation a State of Health (SOH) of the battery pack is provided. The system includes a memory including executable instructions and a transceiver. The transceiver receives a set of operational parameters pertaining to an operation of each of a plurality of cells of the battery pack and a discharge profile of one an exemplary battery pack and the battery pack to determine a discharge capacity of one of the exemplary battery pack and the battery pack utilizing the discharge profile. The system further includes at least one processor in communication with the memory and the transceiver. The at least one processor is configured to determine a first state of health of the battery pack utilizing the set of operational parameters and a first set of stress parameters. The at least one processor is further configured to determine a second state of health of the battery pack based on the determined discharge capacity. Thereafter, the at least one processor is configured to utilize the first state of health and the second state of health to determine a second set of stress parameters of the battery pack for each of a plurality of State of Charge (SOC) ranges of the battery pack. On determination, the at least one processor is configured to dynamically select at least of the second set of stress parameters from the second set of stress parameters, wherein the at least one of the second set of stress parameters corresponds to at least one SOC range of the plurality of SOC ranges. On selection, the at least one processor is configured to determine a third state of health of the battery pack based on the at least one selected second set of stress parameters and the set of operational parameters. Thereafter, the at least one processor is configured to determine a deviation parameter based on the first and the third state of health of the battery pack and transmit an ideal state of health signal to one of a server and a user device of an electric vehicle in response to the determined deviation parameter being greater than a pre-defined threshold.

In yet another embodiment of the present invention, battery pack is disclosed. The batter pack includes a plurality of cells arranged within the battery pack, a sensory unit electrically coupled to the plurality of cells to measure a set of operational parameters pertaining to an operation of each of a plurality of cells of the battery pack, and a battery telematics unit communicably coupled to the plurality of cells. The battery pack further includes at least one processor communicably coupled to each of the sensory unit and the battery telematics unit. The at least one processor is configured to receive the set of operational parameters pertaining to an operation of each of a plurality of cells of the battery pack. Further, the at least one processor is configured to receive a discharge profile of one an exemplary battery pack and the battery pack to determine a discharge capacity of one of the exemplary battery pack and the battery pack utilizing the discharge profile. The at least one processor is configured to determine a first state of health of the battery pack utilizing the set of operational parameters and a first set of stress parameters. The at least one processor is further configured to determine a second state of health of the battery pack based on the determined discharge capacity. Thereafter, the at least one processor is configured to utilize the first state of health and the second state of health to determine a second set of stress parameters of the battery pack for each of a plurality of State of Charge (SOC) ranges of the battery pack. On determination, the at least one processor is configured to dynamically select at least of the second set of stress parameters from the second set of stress parameters, wherein the at least one of the second set of stress parameters corresponds to at least one SOC range of the plurality of SOC ranges. On selection, the at least one processor is configured to determine a third state of health of the battery pack based on the at least one selected second set of stress parameters and the set of operational parameters. Thereafter, the at least one processor is configured to determine a deviation parameter based on the first and the third state of health of the battery pack and transmit an ideal state of health signal to one of a server and a user device of an electric vehicle in response to the determined deviation parameter being greater than a pre-defined threshold.

Other features and aspects of this invention will be apparent from the following description and the accompanying drawings. The features and advantages described in this summary and in the following detailed description are not all-inclusive, and particularly, many additional features and advantages will be apparent to one of ordinary skill in the relevant art, in view of the drawings, specification, and claims hereof. Moreover, it should be noted that the language used in the specification has been principally selected for readability and instructional purposes, and may not have been selected to delineate or circumscribe the inventive subject matter, resort to the claims being necessary to determine such inventive subject matter.

BRIEF DESCRIPTION OF THE DRAWINGS

Reference will be made to embodiments of the invention, examples of which may be illustrated in the accompanying figures. These figures are intended to be illustrative, not limiting. The accompanying figures, which are incorporated in and constitute a part of the specification, are illustrative of one or more embodiments of the disclosed subject matter and together with the description explain various embodiments of the disclosed subject matter and are intended to be illustrative. Further, the accompanying figures have not necessarily been drawn to scale, and any values or dimensions in the accompanying figures are for illustration purposes only and may or may not represent actual or preferred values or dimensions. Although the invention is generally described in the context of these embodiments, it should be understood that it is not intended to limit the scope of the invention to these particular embodiments.

FIG. *1* is a block diagram of an environment to which a system for estimation of State of Health (SOH) of a battery pack is implemented, according to one or more embodiments of the present invention;

FIG. 2 is a schematic representation of the system of FIG. 1 for the estimation of the SOH of the battery pack, according to one or more embodiments of the present invention;

**FIG. 3** is an interaction of an at least one processor with the plurality of functionality modules of the system of **FIG. 2** to estimate the SOH of the battery pack, according to one or more embodiments of the present invention;

**FIG. 4** is a flow chart of a method for estimation of State of Health of a battery pack utilizing the system of **FIG. 2,** according to one or more embodiments of the present invention.

DETAILED DESCRIPTION OF THE INVENTION

Reference will now be made in detail to specific embodiments or features, examples of which are illustrated in the accompanying drawings. Wherever possible, corresponding or similar reference numbers will be used throughout the drawings to refer to the same or corresponding parts. References to various elements described herein, are made collectively or individually when there may be more than one element of the same type. However, such references are merely exemplary in nature. It may be noted that any reference to elements in the singular may also be construed to relate to the plural and vice-versa without limiting the scope of the invention to the exact number or type of such elements unless set forth explicitly in the appended claims. Moreover, relational terms such as first and second, and the like, may be used to distinguish one entity from the other, without necessarily implying any actual relationship or between such entities.

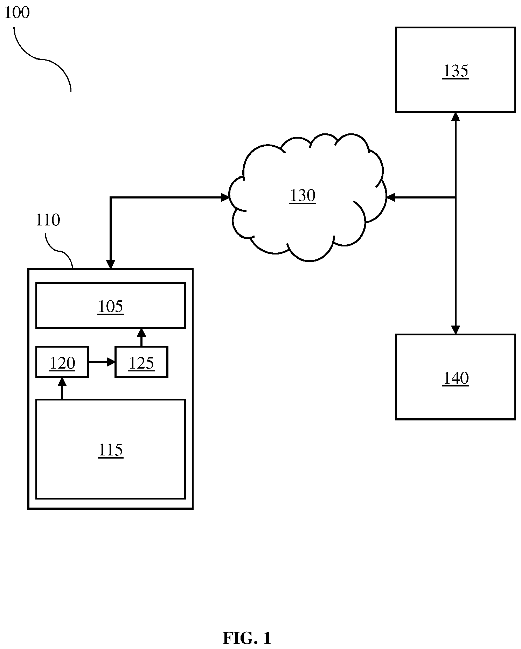

**FIG. 1** illustrates a block diagram of an environment **100** to which a system **105** for estimation of a State of Health (SOH) of a battery pack **110** is implemented, according to one or more embodiments of the present invention. In the illustrated embodiment, the battery pack **110** is employed as an energy source in applications such as transportation, telecom, household appliances, and the like. For the purpose of description, the battery pack **110** may be utilized as an energy source for an electric vehicle. Although the illustrated embodiment depicts a single battery pack **110,** it is to be understood that multiple battery packs may be used as per the requirement, without deviating from the scope of the present disclosure.

The battery pack **110** includes a plurality of cells **115** arranged therein. Each of the plurality of cells **115** is electrically coupled to the each other in one of a series connection, a parallel connection and a combination thereof. In one embodiment, each of the plurality of cells **115** is one of, but not limited to, a Lithium ion (Li-ion), a Lead acid gel, and Nickel metal hydride. In an alternate embodiment, composition of each of the plurality of cells **115** is lithium or lithium polymer cells (referred to as "lithium") combined with a nickel hydrate battery cells. In alternate embodiments, any suitable battery cell composition may be used, including, but not necessarily limited to, lithium ion, zinc air, zinc oxide, super charged zinc oxide, and fuel cells.

The battery pack **115** further includes a plurality of sensors **120** communicably coupled to at least each of the plurality of cells **115** of the battery pack **110**. The plurality of sensors **120** is configured to measure a set of operational parameters pertaining to each of the plurality of cells **115** of the battery pack **110**. The set of operational parameters includes data corresponding to at least one of, but not limited to, depth of discharge, rate of charging/discharging, mean of state of charge (SOC), upper and lower and cut off SOC, and a combination thereof of the battery pack **110**.

The battery pack **110** further includes a battery telematics unit **125** communicably coupled to the plurality of sensors **120** and the system **105** of the battery pack **110**. The battery telematics unit **125** is configured to receive and temporarily store the set of operational parameters of each of the plurality of cells **115** of the battery pack **110**. The battery telematics unit **125** is further configured to transfer the set of operational parameters of each of the plurality of cells **115** to the system **105** to aid in estimation of the SOH of the battery pack **110**.

The system **105** as per the illustrated embodiment in **FIG. 1** is embodied as an integral part of the battery pack **110**. In alternate embodiments, the system **105** is located at a remote location communicably coupled to the battery telematics unit **125** of the battery pack **110**.

In one embodiment, the system **105** is further configured to transmit the set of operational parameters to a server **130** via a network **135**. In one embodiment, subsequent to transmission of the set of operational parameters from the system **105** to the server **130,** copy of the data pertaining to the set of operational parameters is automatically deleted from the system **105**. By doing so, ensures that the system **105** is not accumulated with previously stored data which is already transmitted to the server **130**. Advantageously, the system **105** is not burdened with large volume of data beyond the capacity of the system **105,** thereby ensuring that effective monitoring service is provided and improving the operational efficiency of the system **105**.

It may be understood that the server **130** may be implemented in a variety of computing systems, such as a mainframe computer, a network server, cloud, and the like. The server **130** is in communication with the system **105** of the battery pack **110** via the network **135**. In one embodiment, a Secure Hardware Extension (SHE) unit is embedded within the battery pack **110**. The SHE unit ensures that a secure communication of data takes place between the system **105** and the server **130,** thereby preventing third party access to data. In an embodiment, the network **135** can include wired and/or wireless connections such as, but not limited to, local area network (LAN), Bluetooth, Near Field Communication (NFC), infrared, WIFI, GPRS, LTE, Edge and the like.

In addition, the system **105** is in communication with a user device **140** via the network **135.** As such, the user device **140** receives notifications pertaining to the SOH of the battery pack **110.** In addition, the user device **140** is communicably coupled to the server **135.** Further, one of the server **130** and the system **105** is configured to provide the user with periodic reports regarding SOH of the battery pack **110.** The user device **140** is one of, but not limited to, a mobile phone, a portable computer, a personal digital assistant, a handheld device, a laptop computer, and a communication device, such as, but not limited to, a display unit of the electric vehicle.

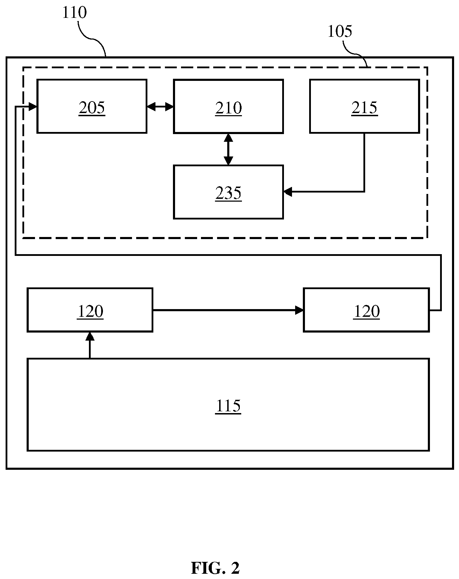

Referring to **FIG. 2, FIG. 2** illustrates a schematic representation of the system **105** for the estimation of the SOH of the battery pack **110,** according to one or more embodiments of the present invention. The system **105** is communicably coupled to the battery telematics unit **125** and the plurality of cells **115** of the battery pack **110.** The system **105** is configured to receive data pertaining to the set of operational parameters of each of the plurality of cells of the battery pack **110** for the estimation of the SOH of the battery pack **110.**

In this regard, the system **105** includes a include a transceiver **205,** at least one processor **210,** an input/output (I/O) interface unit **215,** a memory **220,** and a plurality of functionality modules **225.**

The transceiver **205** of the system **105** may be implemented as a device adapted to aid in one of receiving and transmitting at least one of, but not limited to, the set of operational parameters and the estimated SOH to the at least one processor **210,** the server **130,** and the user device **140.** In the preferred embodiment, the transceiver **205** is configured to receive the set of operational parameters pertaining to operation of each of the plurality of cells **115** of the battery pack **110.** The transceiver **205** is further communicably coupled to the at least one processor **210.**

The at least one processor **210** may be implemented as one or more microprocessors, microcomputers, microcontrollers, digital signal processors, central processing units, state machines, logic circuitries, and/or any devices that manipulate signals based on operational instructions. Among other capabilities, the at least one processor **210** is configured to fetch and execute computer-readable instructions stored in the memory **220.**

The I/O interface unit **215** may include a variety of software and hardware interfaces, for example, a web interface, a graphical user interface, Light Emitting Diode (LED) and the like. The I/O interface unit **215** may allow the user to interact with the system **105** directly or through the user device **140.** Further, the I/O interface unit **215** may enable the system **105** to communicate with other computing devices, such as the server **130** and external data servers (not shown). The I/O interface **215** may facilitate multiple communications within a wide variety of networks and protocol types, including wired networks, for example, LAN, cable, etc., and wireless networks, such as WLAN, cellular, or satellite. In one embodiment, The I/O interface unit **215** may include one or more ports for connecting a number of devices to one another or to another server.

The memory **220** may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes.

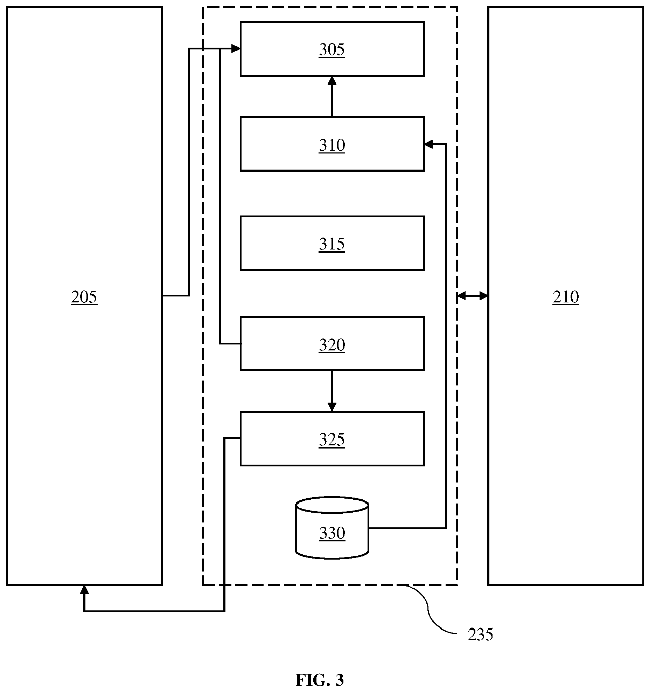

Referring to **FIG. 3, FIG. 3** illustrates an interaction of the at least one processor **210** with the plurality of functionality modules **225** to estimate the SOH of the battery pack **110,** according to one or more embodiments of the present invention. It is to be noted that the word "module," as used herein, refers to logic embodied in hardware or firmware, or to a collection of software instructions, written in a programming language, such as, Java, C, C++, and the like. One or more software instructions in the said modules may be embedded in firmware, such as an EPROM. It will be appreciated that the said modules may include connected logic units, such as gates and flip-flops, and may further include programmable units, such as programmable gate arrays or processors. The said modules as described herein may be implemented as either software and/or hardware modules and may be stored in any type of computer-readable medium or other computer storage device.

Further, while one or more operations have been described as being performed by or otherwise related to certain modules, devices or entities, the operations may be performed by or otherwise related to any module, device or entity. As such, any function or operation that has been described as being performed by a module could alternatively be performed by a different server, by the cloud computing platform, or a combination thereof.

Referring to **FIG. 2** and **FIG. 3,** the at least one processor **210,** hereinafter referred to as "the processor **210",** is configured to interact with the plurality of functionality modules **225** for the estimation of the SOH of the battery pack **110.** In this regard, in one embodiment, the plurality of functionality modules **225** is in communication with the processor **210** and the processor **210** controls the operation of the plurality of functionality modules **235** for the estimation of the SOH of the battery pack **110.** In another embodiment, each of the plurality of functionality modules **225** explained below may be configured to independently perform the respective functions. In an alternate embodiment, the plurality of functionality modules **225** is an integral component of the processor **210.**

The plurality of functionality modules **225** includes, but not limited to, a SOH estimation module **305,** a discharge profile module **310,** a parameter estimation module **315,** a deviation determination module **320,** a decision module **325,** and repository module **330.** At the outset, as mentioned earlier, the battery pack **110** includes the plurality of sensors **120** to measure the set of operational parameters pertaining to the operation of each of the plurality of cells **115** of the battery pack **110.** The battery telematics unit **125** receives the same, and thereafter transmits the set of operational parameters to the transceiver **205** of the system **105.** Subsequently, the transceiver **205** transmits the set of operational parameters to the SOH estimation module **305.** On receiving, the set of operational parameters, the SOH estimation module **305** is configured to estimate a first SOH of the battery pack **110.**

In addition to the set of operational parameters, the SOH estimation module **305** utilizes a first set of stress parameters (ki) for determining the first SOH. The first set of stress parameters ($k_i$) includes multiple parameters that adversely affects operation of the battery pack **110** with respect to parameters such as, but not limited to, the charging rate, State of Charge (SOC) mean, and Depth of Discharge (DOD) of the battery pack **110** considering a current condition in which the battery pack **110** is operating and associated current temperature at which the battery pack **110** is operating. For instance, the current condition of the battery pack **110** may correspond to a mechanical degradation, such as but not limited to, Solid Electrolyte Interphase (SEI) growth on each of the plurality of cells **115** of the battery pack **110.** Also, the SEI growth may vary based on a number of cycles.

As per the preferred embodiment, the first set of stress parameters ($k_i$) includes a set of six (6) parameters ($k_1$, $k_2$, $k_3$, $k_4$, $k_5$, $k_6$). However, in alternate embodiments, the first set of stress parameters (ki) may include more than 6 parameters without deviating from the scope of the present disclosure.

In order to determine the first SOH, the SOH estimation module **305** utilizes a global minima initialization to assign a predefined value to each of the first set of stress parameters ($k_1$, $k_2$, $k_3$, $k_4$, $k_5$, $k_6$) for determining the first SOH. In one embodiment, the predefined value for each of the first set of stress parameters ($k_1$, $k_2$, $k_3$, $k_4$, $k_5$, $k_6$) is set at a minimum value. Accordingly, the SOH estimation module **305** utilizes the set of operational parameters and the first set of stress parameters ($k_1$, $k_2$, $k_3$, $k_4$, $k_5$, $k_6$) to determine the first SOH using the equation as provided below:

$$\text{First SOH(\%)} = 100 - k_1 SOC_M(1 + k_2 DOD + k_3 e^{Crate})\left(\frac{n}{100}\right)^{k_4} - k_5\left(\frac{n}{100}\right)^{k_6}$$

$$\ldots\ldots(Eq.\,)1$$

More specifically, the SOH estimation module **305** utilizes the set of operational parameters, such as the depth of discharge of the battery pack, rate of charging/discharging, mean of state of charge (SOC), and upper and lower and cut off SOC of the battery pack **110** (otherwise termed as the SOC% range), and the first set of stress parameters to determine the first SOH of the battery pack **110** for a known number of cycles (n). By doing so, the SOH estimation module **305,** advantageously, optimizes the predefined value to each of the first set of stress parameters ($k_1$, $k_2$, $k_3$, $k_4$, $k_5$, $k_6$) so that a predefined error between the first SOH (or otherwise termed as the experimental SOH) and a SOH value that may be determined based on simulations, is met.

Simultaneously, the SOH estimation module **305** receives a discharge profile of one of an exemplary battery pack and the battery pack **110** in use from the discharge profile module **310.** In an embodiment, the discharge profile includes a maximal releasable capacity ($C_{max}$) of one of the experimental battery pack and the battery pack after 'n' number of cycles. In general, the SOH of the experimental battery pack is a percentage of the maximal releasable capacity ($C_{max}$) relative to a rated capacity ($C_{rated}$) of one of the experimental battery pack and the battery pack **110.** In one embodiment, the discharge profile includes a set of experimental parameters pertaining to the depth of discharge of the exemplary battery pack, rate of charging/discharging, mean of state of charge (SOC), and upper and lower cut off SOC (otherwise termed as the SOC% range) of the exemplary battery pack. In an alternate embodiment, the discharge profile includes a set of experimental parameters pertaining to the depth of discharge of the battery pack **100,** rate of charging/discharging, mean of state of charge (SOC), and upper and lower cut off SOC of the battery pack **110** (otherwise termed as the SOC% range). The set of experimental parameters, thus obtained, is based on experiments conducted on one of the experimental battery pack and the battery pack **110** for multiple SOC% ranges, such as, but not limited to, 0-100, 5-100, 10-100, 0-95, 5-95, 10-95, 0-90, 5-90, and 10-90.

Further, in one embodiment, the discharge profile module **310** is configured to receive the discharge profile of the exemplary battery pack from the server **130** via the network **135.** In an alternate embodiment, the discharge profile of one of the exemplary battery and the battery pack is stored in a repository module **330.**

As mentioned earlier, the SOH estimation module **305** receives a discharge profile of one of an exemplary battery pack and the battery pack **110** from the discharge profile module **310.** On receiving, the SOH estimation module **305** estimates a second SOH of one of the exemplary battery pack and the battery pack **110** utilizing the set of experimental parameters of the discharge profile, or otherwise based on the determined discharge capacity of one of an exemplary battery pack and the battery pack **110.** Further, in one embodiment, the temperature is considered to be a constant.

Accordingly, the SOH estimation module **305** utilizes the set of experimental parameters received to determine the second SOH using the equation as provided below:

$$\text{Second SOH}(n, DOD, SOC_M, C - rate) = a(DOD, SOC_M, C - rate)f_1(n) +$$

$$b(SOC_M)f_2(n) \ldots Eq.\ 2$$

With respect to the Eq. 2 as provide above, it is to be understood that n is the number of cycles, *DOD* is the depth of discharge, $SOC_M$ is the mean state of charge. *a* and *b* are parameters and assumed to be the function of the DOD, C-rate, $SOC_M$. $f_1$ and $f_2$ are the functions of the cycle number at a given temperature. Further and more specifically, for a given depth of discharge (DOD), state of charge (SOC), C-rate, and number of cycles, the second SOH is determined utilizing the *Eq. 2* and based upon physical and chemical events occurring inside the battery pack **110** during one of charging and discharging process of the same. Thus, the *Eq. 2* aids in defining a mechanism of capacity degradation or decrease in SOH with increase charging-discharging number of cycles as $f_1$ and $f_2$. The function $f_1$ in the *Eq. 2* corresponds to a SEI layer growth associated with a failure mechanism of each of the plurality of cells **115** of the battery pack **110** and the function $f_2$ corresponds to a cycling aging due to mechanical stress generated in the electrode material of each of the plurality of cells **115** of the battery pack **110** during cycling process.

Furthermore, the SOH estimation module **305** in communication with the parameter estimation module **315** utilizes the *Eq. 1* and the *Eq. 2* as provided above to determine a second set of stress parameters ($k_i$) utilizing models such as, but not limited to, Levenberg- Marquardt model. In a preferred embodiment, the parameter estimation module **315** determines multiple sets of stress parameters ($k_i$). Each of the multiple second set of stress parameters corresponds to each of the multiple SOC% ranges, such as, but not limited to, 0-100, 5-100, 10-100, 0-95, 5-95, 10-95, 0-90, 5-90, and 10-90, respectively. Accordingly, the parameter estimation module determines the second set of stress parameter for each of the multiple SOC % ranges.

As per the preferred embodiment and similar to the first set of stress parameters ($k_i$), the second set of stress parameters ($k_i$) includes six (6) parameters ($k_1, k_2, k_3, k_4, k_5, k_6$). However, in alternate embodiments, the second set of stress parameters ($k_i$) may include more than 6 parameters without deviating from the scope of the present disclosure.

On determination of the second set of stress parameters ($k_1, k_2, k_3, k_4, k_5, k_6$), the parameter estimation module **315** transfers the determined second set of stress parameters ($k_1, k_2, k_3, k_4, k_5, k_6$) to the SOH estimation module **305**. Thereafter, the SOH estimation module **305** dynamically selects at least one of the second set of stress parameters from the multiple sets of stress parameters. The SOH estimation module **305** utilizes the dynamically selected second set of stress parameters and set of operational parameters as per the *Eq. 1* as provided above to determine a third SOH of the battery pack **110**.

Thereafter, the SOH estimation module **305** provides the first SOH and the third SOH as determined to the deviation determination module **320**. The deviation determination module **320** is configured to determine a deviation parameter ($R^2$) based on the first and the third SOH of the battery pack **110**. In order to determine the deviation parameter ($R^2$), the deviation parameter module **320** utilizes each of the first and the third SOH to determine an experimental capacity ($C_E$) and a theoretical capacity ($C_T$) of the battery pack **110**. Thereafter, the deviation parameter module **320** utilizes the experimental capacity ($C_E$) and the theoretical capacity ($C_T$) of the battery pack **110** to determine the deviation parameter ($R^2$) via the equation as provided below:

$$R^2 = 1 - \left[ \frac{\sum_i \left( C_{T,i} - C_{E,i} \right)^2}{\sum_i \left( C_{T,i} - \overline{C_E} \right)^2} \right] \ldots \ldots Eq.\ 3$$

On determination of the deviation parameter ($R^2$), the deviation determination module **320** is configured to compare the deviation parameter ($R^2$) to a pre-defined threshold. In one embodiment, the pre-defined threshold is set at 0.9. In an alternate embodiment, the pre-defined threshold is about 0.9. On comparison, if the determined deviation parameter ($R^2$) is lesser than the pre-defined threshold, the deviation determination module **320** instructs the SOH estimation module **305** to determine the third SOH of the battery pack utilizing the set of operational parameters and at least one of remaining second set of stress parameters from the multiple second set of stress parameters not dynamically selected previously.

On comparison, if the determined deviation parameter ($R^2$) is greater than the pre-defined threshold, the deviation determination module **320** instructs the decision module **325** of the same. Consequently, the decision module **325** is configured to transmit an ideal SOH signal to one of the server **130**, the user device **140**, and a combination thereof.

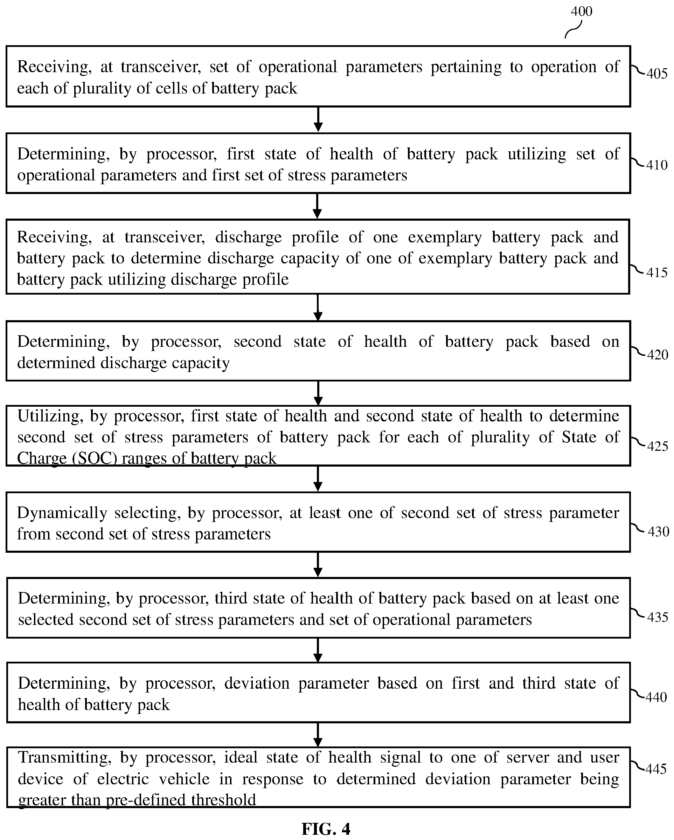

FIG. 4 is a flow chart of a method **400** for estimation of State of Health (SOH) of a battery pack **110** utilizing a system **105**, according to one or more embodiments of the present invention. For the purpose of description, the method **400** is described with the embodiments as illustrated in **FIGs 2-3**. Further, in order to avoid repetition and for the sake of brevity, the description for the **FIGs 2-3** should be referred and should nowhere be construed as limiting the scope of the present disclosure.

At step **405,** the method **400** includes the step of receiving, at a transceiver **205,** a set of operational parameters pertaining to an operation of each of a plurality of cells **115** of the battery pack **110.**

At step **410,** the method **400** includes the step of determining, by the processor **210,** a first state of health of the battery pack **110** utilizing the set of operational parameters and a first set of stress parameters.

At step **415,** the method **400** includes the step of receiving, at the transceiver **205,** a discharge profile of one an exemplary battery pack and the battery pack **110** to determine a discharge capacity of one of the exemplary battery pack and the battery pack **110** utilizing the discharge profile.

At step **420,** the method **400** includes the step of determining, by the processor **210,** a second state of health of the battery pack **110** based on the determined discharge capacity.

At step **425,** the method **400** includes the step of utilizing, by the processor **210,** the first state of health and the second state of health to determine a second set of stress parameters of the battery pack **110** for each of a plurality of State of Charge (SOC) ranges of the battery pack **110.**

At step **430,** the method **400** includes the step of dynamically selecting, by the processor **210,** at least one of the second set of stress parameter from the second set of stress parameters. The at least one of the second set of stress parameter corresponds to at least one SOC range of the plurality of SOC ranges.

At step **435,** the method **400** includes the step of determining, by the processor **210,** a third state of health of the battery pack **110** based on the at least one selected second set of stress parameters and the set of operational parameters.

At step **440,** the method **400** includes the step of determining, by the processor **210,** a deviation parameter based on the first and the third state of health of the battery pack **110.**

At step **445,** the method **400** includes the step of transmitting, by the processor, an ideal state of health signal to one of a server **130** and a user device **140** of an electric vehicle in response to the determined deviation parameter being greater than a pre-defined threshold.

Various embodiments disclosed herein are to be taken in the illustrative and explanatory sense and should in no way be construed as limiting of the present invention. While aspects of the present invention have been particularly shown and described with reference to the embodiments above, it will be understood by those skilled in the art that various additional embodiments may be contemplated by the modification of the disclosed machines, systems and methods without departing from the scope of what is disclosed. Such embodiments should be understood to fall within the scope of the present invention as determined based upon the claims and any equivalents thereof.

## Claims

1. A method for estimation of a state of health of a battery pack, the method comprising:

    receiving, at a transceiver, a set of operational parameters pertaining to an operation of each of a plurality of cells of the battery pack;
    determining, by the processor, a first state of health of the battery pack utilizing the set of operational parameters and a first set of stress parameters;
    receiving, at the transceiver, a discharge profile of one an exemplary battery pack and the battery pack to determine a discharge capacity of one of the exemplary battery pack and the battery pack utilizing the discharge profile;
    determining, by the processor, a second state of health of the battery pack based on the determined discharge capacity;
    utilizing, by the processor, the first state of health and the second state of health to determine a second set of stress parameters of the battery pack for each of a plurality of State of Charge (SOC) ranges of the battery pack;
    dynamically selecting, by the processor, at least one of the second set of stress parameter from the second set of stress parameters, wherein the at least one of the second set of stress parameter corresponds to at least one SOC range of the plurality of SOC ranges;
    determining, by the processor, a third state of health of the battery pack based on the at least one selected second set of stress parameters and the set of operational parameters;
    determining, by the processor, a deviation parameter based on the first and the third state of health of the battery pack; and
    transmitting, by the processor, an ideal state of health signal to one of a server and a user device of an electric vehicle in response to the determined deviation parameter being greater than a pre-defined threshold.

2. The method as claimed in claim 1, wherein the set of operational parameters is at least one of depth of discharge of the battery pack, rate of charging/discharging, mean of state of charge (SOC), and upper and lower and cut off SOC.

3. The method as claimed in claim 1, wherein the set of operational parameters pertain to operation of the battery pack, wherein each of the operational parameter is received at a particular instant of time during the operation of the battery pack.

4. The method as claimed in claim 1, wherein the discharge profile pertains to a set of predetermined operational parameters corresponding to a set of discharged voltages during operation of one of the exemplary battery pack and the battery pack.

5. The method as claimed in claim 1, wherein the second set of stress parameters is determined based on a function of a difference of the second state of health and the first state of health determined.

6. The method as claimed in claim 1, wherein in response to the determined deviation parameter being lesser than the pre-defined threshold, the processor is configured to, determine the third state of health of the battery pack utilizing the set of operational parameters and at least one of remaining second set of stress parameters from the second set of stress parameters not dynamically selected previously.

7. A system for estimation of state of health of a battery pack, the system comprising:

   a memory including executable instructions;
   a transceiver to receive a set of operational parameters pertaining to an operation of each of a plurality of cells of the battery pack and a discharge profile of one an exemplary battery pack and the battery pack to determine a discharge capacity of one of the exemplary battery pack and the battery pack utilizing the discharge profile; and
   at least one processor in communication with the memory and the transceiver, the at least one processor configured to receive the executable instructions and configured to:

   determine a first state of health of the battery pack utilizing the set of operational parameters and a first set of stress parameters;
   determine a second state of health of the battery pack based on the determined discharge capacity;
   utilize the first state of health and the second state of health to determine a second set of stress parameters of the battery pack for each of a plurality of State of Charge (SOC) ranges of the battery pack;
   dynamically select at least of the second set of stress parameters from the second set of stress parameters, wherein the at least one of the second set of stress parameters corresponds to at least one SOC range of the plurality of SOC ranges;
   determine a third state of health of the battery pack based on the at least one selected second set of stress parameters and the set of operational parameters;
   determine a deviation parameter based on the first and the third state of health of the battery pack; and
   transmit an ideal state of health signal to one of a server and a communication device of an electric vehicle in response to the determined deviation parameter being greater than a pre-defined threshold.

8. The system as claimed in claim 7, wherein the processor is further configured to determine the third state of health of the battery pack utilizing the set of operational parameters and at least one of remaining second set of stress parameters from the second set of stress parameters not dynamically selected previously in response to the determined deviation parameter being lesser than the pre-defined threshold.

9. A battery pack comprising:

   a plurality of cells arranged within the battery pack;
   a plurality of sensors electrically coupled to the plurality of cells to measure a set of operational parameters pertaining to an operation of each of a plurality of cells of the battery pack;
   a battery telematics unit communicably coupled to the plurality of cells and the plurality of sensors; and
   at least one processor communicably coupled to each of the sensory unit and the battery telematics unit, the processor configured to:

   receive the set of operational parameters pertaining to an operation of each of a plurality of cells of the battery pack;

determine a first state of health of the battery pack utilizing the set of operational parameters and a first set of stress parameters;

receive a discharge profile of one an exemplary battery pack and the battery pack to determine a discharge capacity of one of the exemplary battery pack and the battery pack utilizing the discharge profile;

determine a second state of health of the battery pack based on the determined discharge capacity;

utilize the first state of health and the second state of health to determine a second set of stress parameters of the battery pack for each of a plurality of State of Charge (SOC) ranges of the battery pack;

dynamically select at least of the second set of stress parameters from the second set of stress parameters, wherein the at least one of the second set of stress parameters corresponds to at least one SOC range of the plurality of SOC ranges;

determine a third state of health of the battery pack based on the at least one selected second set of stress parameters and the set of operational parameters;

determine a deviation parameter based on the first and the third state of health of the battery pack; and

transmit an ideal state of health signal to one of a server and a user device of an electric vehicle in response to the determined deviation parameter being greater than a pre-defined threshold.

10. The system as claimed in claim 9, wherein the processor is further configured to determine the third state of health of the battery pack utilizing the set of operational parameters and at least one of remaining second set of stress parameters from the second set of stress parameters not dynamically selected previously in response to the determined deviation parameter being lesser than the pre-defined threshold.

100

110

105

120 → 125

115

130

135

140

**FIG. 1**

**FIG. 2**

**FIG. 3**

400

Receiving, at transceiver, set of operational parameters pertaining to operation of each of plurality of cells of battery pack ~405

↓

Determining, by processor, first state of health of battery pack utilizing set of operational parameters and first set of stress parameters ~410

↓

Receiving, at transceiver, discharge profile of one exemplary battery pack and battery pack to determine discharge capacity of one of exemplary battery pack and battery pack utilizing discharge profile ~415

↓

Determining, by processor, second state of health of battery pack based on determined discharge capacity ~420

↓

Utilizing, by processor, first state of health and second state of health to determine second set of stress parameters of battery pack for each of plurality of State of Charge (SOC) ranges of battery pack ~425

↓

Dynamically selecting, by processor, at least one of second set of stress parameter from second set of stress parameters ~430

↓

Determining, by processor, third state of health of battery pack based on at least one selected second set of stress parameters and set of operational parameters ~435

↓

Determining, by processor, deviation parameter based on first and third state of health of battery pack ~440

↓

Transmitting, by processor, ideal state of health signal to one of server and user device of electric vehicle in response to determined deviation parameter being greater than pre-defined threshold ~445

**FIG. 4**

Europäisches
Patentamt

European
Patent Office

Office européen
des brevets

# EUROPEAN SEARCH REPORT

Application Number

EP 23 18 0316

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/268927 A1 (SHIMONISHI YUTA [JP] ET AL) 2 September 2021 (2021-09-02) * the whole document * | 1-10 | INV. G01R31/382 G01R31/392 G01R31/396 |
| A | US 2020/227791 A1 (FLUECKIGER RETO [CH] ET AL) 16 July 2020 (2020-07-16) * figure 1 * | 1-10 | |
| A | US 2022/149645 A1 (RAMANUJAM MURALIKRISHNAN [IN] ET AL) 12 May 2022 (2022-05-12) * figures 1,2 * | 1-10 | |

TECHNICAL FIELDS
SEARCHED       (IPC)

G01R

The present search report has been drawn up for all claims

| Place of search | Date of completion of the search | Examiner |
|---|---|---|
| Munich | 23 November 2023 | Schindler, Martin |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

                               

& : member of the same patent family, corresponding
      document

EPO FORM 1503 03.82 (P04C01)

**EP 4 300 111 A1**

## ANNEX TO THE EUROPEAN SEARCH REPORT
## ON EUROPEAN PATENT APPLICATION NO.

EP 23 18 0316

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2023

| Patent document cited in search report | | Publication date | Patent family member(s) | | Publication date |
|---|---|---|---|---|---|
| US 2021268927 | A1 | 02-09-2021 | CN | 113325316 A | 31-08-2021 |
| | | | CN | 113777498 A | 10-12-2021 |
| | | | JP | 2021136182 A | 13-09-2021 |
| | | | US | 2021268927 A1 | 02-09-2021 |
| US 2020227791 | A1 | 16-07-2020 | AU | 2018331966 A1 | 20-08-2020 |
| | | | CN | 111095663 A | 01-05-2020 |
| | | | EP | 3682502 A1 | 22-07-2020 |
| | | | JP | 7266587 B2 | 28-04-2023 |
| | | | JP | 2020533772 A | 19-11-2020 |
| | | | US | 2020227791 A1 | 16-07-2020 |
| | | | WO | 2019053131 A1 | 21-03-2019 |
| US 2022149645 | A1 | 12-05-2022 | EP | 3995346 A1 | 11-05-2022 |
| | | | US | 2022149645 A1 | 12-05-2022 |

EPO FORM P0459

For more details about this annex : see Official Journal of the European Patent Office, No. 12/82